# EUROPEAN PATENT SPECIFICATION

(11) **EP 2 570 899 B1**
(45) Date of publication and mention of the grant of the patent: **08.11.2017**
(21) Application number: 12183962.5
(22) Date of filing: 12.09.2012
(51) Int. Cl.: G06F 3/041, B32B 7/12

(54) **Touch display device and a method of manufacturing the same**
Berührungsanzeigevorrichtung und Verfahren zu deren Herstellung
Dispositif d'écran tactile et son procédé de fabrication

(30) Priority: 18.09.2011 CN 201110289572
(43) Date of publication of application: 20.03.2013
(73) Proprietor: TPK Touch Solutions (Xiamen) Inc., Xiamen, Fujian 361009 (CN)
(72) Inventor: Lee, Yuh-Wen, 302 Zhubei (TW); Jiang, Yau-Chen, 302 Zhubei City (TW); Huang, Pingping, Sanming City (CN); Luo, Jianxing, Jianyang City (CN)
(74) Representative: 2K Patentanwälte Blasberg Kewitz & Reichel

(56) References cited:
- WO-A2-2011/112447
- TW-A- 201 102 698
- US-A1- 2009 185 101
- US-A1- 2010 302 195
- US-A1- 2011 005 662

## Description

### FIELD OF THE INVENTION

The present disclosure relates to touch technology, and more particularly to a touch display device and a method of manufacturing the same.

### BACKGROUND OF THE INVENTION

Conventional touch display devices usually comprise of a touch panel and a display module. The touch panel mainly comprises a touch substrate and a lens, and a touch sensing layer is formed on the surface of the touch substrate. In a standard production process, a lens and a touch substrate are usually laminated first to form a touch panel, and then the touch panel and a display module are laminated. When laminating the touch panel and the display module, a light-curing liquid adhesive is used. On the edge of the lens of a touch display device, there is a printing ink layer which has characteristics of light shading, which causes incomplete curing of the light-curing liquid adhesive because part of the light-curing liquid adhesive is shaded. Shading affects bonding between the liquid adhesive and leads to reduction in yield of lamination between the touch panel and the display module.

US 2011 005 662 A relates to a method for fabricating a plurality of touch sensor panels. The method includes forming a plurality of touch substrate units having a plurality of drive lines and sense lines on at least one of first and second surfaces of a touch substrate mother sheet; forming an adhesive layer on the first surface of the touch substrate mother sheet covering at least part of each of the plurality of touch substrate units; affixing a cover glass mother sheet having a plurality of cover glass units to the adhesive layer of the touch substrate mother sheet to form a laminate; and separating the laminate into a plurality of panels, each panel including a touch substrate unit laminated to a cover glass unit.

WO 2011 112447 A relates to method of making a display assembly which includes the steps of attaching a first substrate and a second substrate with an optically clear heat activated adhesive to form a laminate. Each of the first and second substrate has opposing major surfaces. At least one of the first and second substrate has a three dimensional surface topography covering at least a portion of one of its major surfaces or is distortion sensitive. At a heat activation temperature, the adhesive is pressure sensitive. The method also includes heating the laminate to the heat activation temperature of the adhesive causing the adhesive to flow.

TW 2011 02698 A relates to relates to a single-layer capacitive touch panel and its fabrication method, which includes a glass cover plate, a touch-sensing circuit layer, an insulting ink layer, a conductive wire layer, an insulating layer and a conductive paste layer. The touch sensing circuit layer, insulating ink layer, the conductive wire layer, the insulating layer and conductive paste play are stacked on the circuit on the glass cover plate in sequence, and the insulating ink layer covers on the touch sensing circuit layer. A flexible printed circuit board is fixed by the conductive paste layer and is electrically connected with conductive wire layer through the conductive paste layer. The touch panel of this invention uses one layer of glass only so that the light transmissivity is better and has less thickness and lower cost.

### SUMMARY OF THE INVENTION

An objective of the present disclosure is to provide a manufacturing method according to claim 1 and a device according to claim 8. The disclosure further relates to complete curing of a light-curing liquid adhesive by changing the order of lamination of a display module, a touch substrate, and a lens so as to improve the yield of lamination between the touch panel and the display module.

A method of manufacturing a touch display device comprises of:
step (a): laminating a display module to a surface of a touch substrate by a first liquid adhesive, the touch substrate being substantially transparent;
step (c): performing light curing of the first adhesive to form a first adhesive layer;
step (b): laminating a lens to the other surface of the touch substrate by a second liquid adhesive, wherein a shading area is formed by covering printing ink around the lens on the edge thereof; and
step (d): performing light curing of the second adhesive to form a second adhesive layer.

The first liquid adhesive is a light-curing liquid adhesive. The second liquid adhesive is also a light-curing liquid adhesive. The light-curing liquid adhesive may include an ultraviolet-curing liquid adhesive, a heat-induced ultraviolet-curing liquid adhesive, and a moisture-induced ultraviolet-curing liquid adhesive.

In an embodiment, first liquid adhesive can be applied on specific portions between display module and touch substrate instead of applying on complete area. Similarly, second liquid adhesive can be applied on specific portions between lens and the touch substrate instead of applying on complete area.

Between the step (a) and the step (b), the method of manufacturing a touch display device comprises the step (c): performing light curing of the first liquid adhesive to form a first adhesive layer.

After the step (b), the method of manufacturing a touch display device comprises the step (d): performing light curing of the second liquid adhesive to form a second adhesive layer.

In an embodiment, if the first and the second liquid adhesives are heat-induced ultraviolet-curing liquid adhesives, the light curing operation further comprises:
performing light curing of the heat-induced ultraviolet-curing liquid adhesive by an ultraviolet light; and
strengthening curing of the heat-induced ultraviolet-curing liquid adhesive by a heating program.

In another embodiment, if the first liquid adhesive and the second liquid adhesive are moisture-induced ultraviolet-curing liquid adhesives, the light curing operation further comprises:
performing light curing of the moisture-induced ultraviolet-curing liquid adhesive by an ultraviolet light; and
strengthening curing of the moisture-induced ultraviolet-curing liquid adhesive by moisture.

The method of manufacturing the touch display device further comprises the step of laminating a flexible circuit board to a touch substrate.

A touch display device of the present disclosure comprises of a touch substrate, a display module and a first adhesive layer, wherein the first adhesive layer laminates the touch substrate and the display module.

The first adhesive layer is formed by an ultraviolet-curing liquid adhesive.

The touch display device further comprises: a lens and a second adhesive layer, wherein the second adhesive layer laminates the touch substrate layer and the lens, and a shading layer is formed around the lens.

A touch sensing layer and a surrounding circuit layer, which is electrically connected to the touch sensing layer are formed on the touch substrate.

Above-mentioned method allows manufacturing of a touch display device, wherein the touch substrate is substantially transparent and there is no shading caused by the shading layer on the edge of the lens such that ultraviolet light can pass through and completely irradiate the liquid adhesive, which can make the ultraviolet-curing liquid adhesive completely light-cured, thereby improving the yield of lamination between the touch panel and the display module.

### BRIEF DESCRIPTION OF THE DRAWINGS

FIG. 1 is a schematic structural view of a touch display device in accordance with embodiments of the present disclosure;
FIG. 2 is a flowchart of a method of manufacturing a touch display device in accordance with embodiments of the present disclosure.

### DETAILED DESCRIPTION OF THE EMBODIMENTS

Detailed description for technical characteristics and advantages of the present disclosure will be disclosed in the following embodiments combined with drawings. It should be noted that in a circumstance of no further description, the elements, structures and characteristics of one embodiment can be combined with other embodiments.

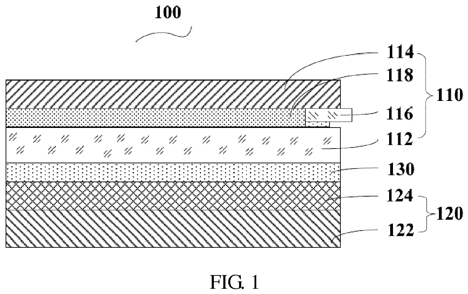

Referring to FIG. 1, a touch display device 100 in accordance with the embodiment comprises a touch panel 110, a display module 120 and a first adhesive layer 130 which laminates the touch panel 110 and the display module 120. The first liquid adhesive layer 130 can be formed by curing one or more of an ultraviolet-curing liquid adhesive, a heat-induced ultraviolet-curing liquid adhesive, or a moisture-induced ultraviolet-curing liquid adhesive. Preferably, an ultraviolet-curing liquid adhesive is used. The ultraviolet-curing liquid adhesive is a liquid adhesive which can be cured into a solid state under irradiation of ultraviolet light of a proper wavelength, wherein the liquid adhesive could either be an acrylic or a silicon-based product.

The touch panel 110 comprises a touch substrate 112, a lens 114, and a second adhesive layer 118, which laminates the touch substrate 112 and the lens 114. A shading area (not shown in FIG. 1) is formed by covering printing ink around the lens 114, and a touch sensing layer (not shown in FIG. 1) is formed on the surface of the touch substrate 112. The touch panel 110 further comprises of a flexible circuit board 116 which is laminated on to the touch substrate 112. A surrounding circuit layer (not shown in FIG. 1) can further be disposed on the touch substrate 112. The touch sensing layer is electrically connected to the surrounding circuit layer, and the surrounding circuit layer is electrically connected to the flexible circuit board 116.

The lens 114 can be made of a glass, plastic or any other material and disposed to protect the touch display device 100 and improve strength of the touch display device 100. The touch substrate 112 is an element disposed to realize the touch technology and can be made of a transparent ITO (Indium Tin Oxide) glass or a film which is processed by a thin-film technology. The touch substrate 112 can be a resistive touch substrate or a capacitive touch substrate. The flexible circuit board 116 is a bridge connecting the touch substrate layer 112 and the touch system, wherein the flexible circuit board 116 usually comprises of an IC (integrated circuit) and other elements, which can compute collected touch information. The second adhesive layer 118 can be formed by curing of one or more of an ultraviolet-curing liquid adhesive, a heat-induced ultraviolet-curing liquid adhesive, or a moisture-induced ultraviolet-curing liquid adhesive. Preferably, the heat-induced ultraviolet-curing liquid adhesive or the moisture-induced ultraviolet-curing liquid adhesive is used.

The heat-induced ultraviolet-curing liquid adhesive is a liquid adhesive which can be cured into a solid state under irradiation of an ultraviolet light of a proper wavelength, and the area that is not irradiated by the ultraviolet light can then be cured by heat. The moisture-induced ultraviolet-curing liquid adhesive is a liquid adhesive which can be cured into a solid state under the irradiation of an ultraviolet light of a proper wavelength, and the area that is not irradiated by the ultraviolet light can then be cured by moisture. The heat-induced ultraviolet-curing liquid adhesive or the moisture-induced ultraviolet-curing liquid adhesive can either be acryl-based or silicon-based product.

The display module 120 comprises of a display panel 122 and at least one diffuser 124 which is laminated to the display 122. The first adhesive layer 130 is disposed between the diffuser 124 and the touch substrate 112. The display 122 could be any of liquid crystal display (LCD), organic light-emitting diode display (OLED), interferometric modulator display (IMOD), cathode ray tube display, plasma display or E-paper display.

An exemplary method of manufacturing a touch display device 100 comprises the steps of:
step (a): laminating a display module 120 to a surface of a touch substrate 112 by a first liquid adhesive;
step (b): laminating a lens 114 to other surface of the touch substrate 112 by a second liquid adhesive;
step (c): performing light curing of the first liquid adhesive to form a first adhesive layer 130; and
step (d): performing light curing of the second liquid adhesive to form a second adhesive layer 118.

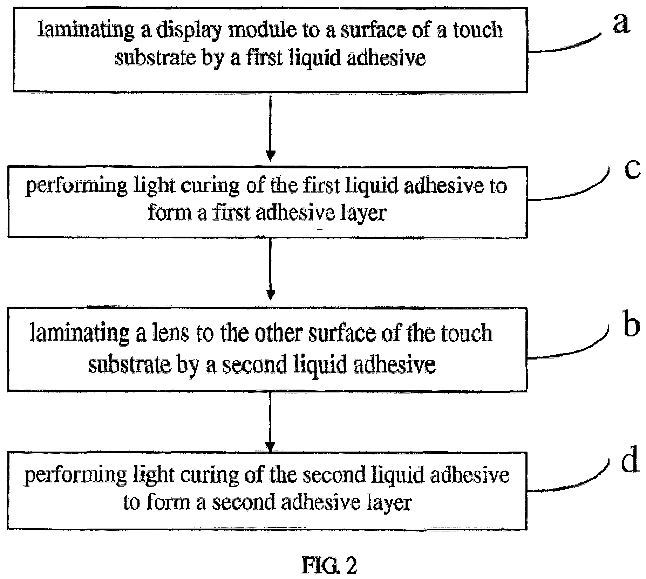

As illustrated in FIG. 2, between step (a) and step (b), the method of manufacturing a touch display device comprises a step (c): performing light curing of the first liquid adhesive to form a first adhesive layer.

The first liquid adhesive and the second liquid adhesive are light-curing liquid adhesives including but not limited to ultraviolet-curing liquid adhesive, heat-induced ultraviolet-curing liquid adhesive, or moisture-induced ultraviolet-curing liquid adhesive.

In an embodiment, if heat-induced ultraviolet-curing liquid adhesive is used, the method of light curing comprises:
performing light curing of the heat-induced ultraviolet-curing liquid adhesive by ultraviolet light; and
strengthening curing of the heat-induced ultraviolet-curing liquid adhesive by a heating program, wherein the heating program can be a well known and conventional heating mechanism.

In an embodiment, if moisture-induced ultraviolet-curing liquid adhesive is used, the method of light curing comprises:
performing light curing of the moisture-induced ultraviolet-curing liquid adhesive by ultraviolet light; and
strengthening curing of the moisture-induced ultraviolet-curing liquid adhesive by moisture.

In step (a) of Fig. 2, a flexible circuit board 116 can be laminated to the touch substrate 112 first and then the touch substrate 112 alongwith the flexible circuit board 116 can be laminated to the display module 120.

When the touch panel and the display module are laminated by a conventional method, ultraviolet light is unable to pass through the shading layer formed by printing ink on the lens, leading to incomplete light curing of the light-curing liquid adhesive under the printing ink of the lens. An advantage of using the present method is that the touch substrate layer and the flexible circuit board are substantially transparent, such that the ultraviolet-curing liquid adhesive can be completely light-cured to form an adhesive layer through ultraviolet irradiation. Moreover, there is no influence of printing ink on the lens, and therefore the ultraviolet-curing liquid adhesive is completely light-cured.

Although the present disclosure has been described with reference to the embodiments and the best mode, it is apparent to those skilled in the art that a variety of modifications and changes can be made without departing from the scope of the present disclosure, which is defined by the appended claims.

## Claims

1. A method of manufacturing a touch display device (100), comprising the steps of:
(a) laminating a display module (120) to a surface of a touch substrate (112) by a first adhesive, the touch substrate (112) being substantially transparent wherein a substantially transparent flexible circuit board (116) is laminated on the touch substrate (112);
(c) performing light curing of the first adhesive to form a first adhesive layer (130);
(b) laminating a lens (114) to the other surface of the touch substrate (112) by a second adhesive, wherein a shading area is formed by covering printing ink around the lens (114) and
(d) performing light curing of the second adhesive to form a second adhesive layer (118).

2. The method of manufacturing a touch display device as claimed in claim 1, wherein the first adhesive is a light-curing liquid adhesive.

3. The method of manufacturing a touch display device as claimed in claim 1, wherein the second adhesive is a light-curing liquid adhesive.

4. The method of manufacturing a touch display device as claimed in claim 2 or 3, wherein the light-curing liquid adhesive is selected from a group comprising of an ultraviolet-curing liquid adhesive, a heat-induced ultraviolet-curing liquid adhesive, a moisture-induced ultraviolet-curing liquid adhesive, or a combination thereof.

5. The method of manufacturing a touch display device as claimed in claim 1, wherein if the first adhesive and the second adhesive are heat-induced ultraviolet-curing liquid adhesives, the light curing operation further comprises:
performing light curing of the heat-induced ultraviolet-curing liquid adhesive by ultraviolet light; and
strengthening curing of the heat-induced ultraviolet-curing liquid adhesive by a heating program.

6. The method of manufacturing a touch display device as claimed in claim 1, wherein if the first adhesive and the second adhesive are moisture-induced ultraviolet-curing liquid adhesives, the light curing operation further comprises:
performing light curing of the moisture-induced ultraviolet-curing liquid adhesive by ultraviolet light; and
strengthening curing of the moisture-induced ultraviolet-curing liquid adhesive by moisture.

7. A touch display device (100) obtained by the manufacturing method according to claim 1.

8. The touch display device as claimed in claim 7, wherein the first adhesive layer and the second adhesive layer is selected from a group comprising of an ultraviolet-curing liquid adhesive, a heat-induced ultraviolet-curing liquid adhesive, a moisture-induced ultraviolet-curing liquid adhesive, and a combination thereof

9. The touch display device as claimed in claim 8, wherein the first adhesive layer is an acrylic or a silicon-based product.

10. The touch display device as claimed in claim 8, wherein the second adhesive layer is an acrylic or a silicon-based product.

11. The touch display device as claimed in claim 7, wherein a touch sensing layer, and a surrounding circuit layer electrically connected to the touch sensing layer are formed on the touch substrate.

## Patentansprüche

1. Verfahren zur Herstellung einer Berührungsanzeigevorrichtung (100), umfassend die Schritte:
(a) Laminieren eines Anzeigemoduls (120) auf eine Oberfläche eines Berührungssubstrats (112) durch ein erstes Haftmittel, wobei das Berührungssubstrat (112) im Wesentlichen transparent ist; wobei ein im Wesentlichen transparente Platine auf dem Berührungssubstrat (112) laminiert wird;
c) Durchführen einer Lichthärtung des ersten Haftmittels unter Bildung einer ersten Haftschicht (130);
(b) Laminieren einer Linse (114) bezüglich der anderen Oberfläche des Berührungssubstrats (112) durch ein zweites Haftmittel, wobei ein Schattierungsbereich durch Abdecken mit Druckfarbe um die Linse (114) herum ausgebildet wird; und
(d) Durchführen einer Lichthärtung des zweiten Haftmittels unter Bildung einer zweiten Haftschicht (118).

2. Verfahren zur Herstellung einer Berührungsanzeigevorrichtung nach Anspruch 1, wobei das erste Haftmittel ein lichthärtender flüssiger Klebstoff ist.

3. Verfahren zur Herstellung einer Berührungsanzeigevorrichtung nach Anspruch 1, wobei das zweite Haftmittel ein lichthärtender flüssiger Klebstoff ist.

4. Verfahren zur Herstellung einer Berührungsanzeigevorrichtung nach Anspruch 2 oder 3, wobei der lichthärtende flüssige Klebstoff aus einer Gruppe ausgewählt wird, die einen ultraviolett härtenden flüssigen Klebstoff, einen Wärme-induzierten ultraviolett härtenden flüssigen Klebstoff, einen Feuchtigkeits-induzierten ultraviolett härtenden flüssigen Klebstoff oder eine Kombination davon umfasst.

5. Verfahren zur Herstellung einer Berührungsanzeigevorrichtung nach Anspruch 1, wobei, wenn das erste Haftmittel und das zweite Haftmittel Wärme-induzierte ultraviolett härtende flüssige Haftmittel sind, der Lichthärtungs-Vorgang ferner umfasst:
Durchführen einer Lichthärtung des Wärme-induzierten ultraviolett härtenden flüssigen Haftmittels durch ultraviolettes Licht; und
Verstärkung der Aushärtung des Wärme-induzierten ultraviolett härtenden flüssigen Haftmittels durch ein Beheizungsprogramm.

6. Verfahren zur Herstellung einer Berührungsanzeigevorrichtung nach Anspruch 1, wobei, wenn das erste Haftmittel und das zweite Haftmittel Feuchtigkeits-induzierte ultraviolett härtende flüssige Haftmittel sind, der Lichthärtungs-Vorgang ferner umfasst:
Durchführen einer Lichthärtung des Feuchtigkeits-induzierten ultraviolett härtenden flüssigen Haftmittels durch ultraviolettes Licht; und
Verstärkung der Aushärtung des Feuchtigkeits-induzierten ultraviolett härtenden flüssigen Haftmittels durch Feuchtigkeit.

7. Berührungsanzeigevorrichtung (100) geschaffen nach dem Herstellungsverfahren gemäß Anspruch 1.

8. Berührungsanzeigevorrichtung nach Anspruch 7, wobei die erste Haftschicht und die zweite Haftschicht aus einer Gruppe ausgewählt sind, die einen ultraviolett härtenden flüssigen Klebstoff, einen Wärme-induzierten ultraviolett härtenden flüssigen Klebstoff, einen Feuchtigkeits-induzierten ultraviolett härtenden flüssigen Klebstoff oder eine Kombination davon umfasst.

9. Berührungsanzeigevorrichtung nach Anspruch 8, wobei die erste Haftschicht ein Acryl- oder Silikonprodukt ist.

10. Berührungsanzeigevorrichtung nach Anspruch 8, wobei die zweite Haftschicht ein Acryl- oder Silikonprodukt ist.

11. Berührungsanzeigevorrichtung nach Anspruch 7, wobei ein Berührungssubstrat eine Berührungssensorschicht und eine umgebende Schaltkreisschicht, die elektrisch mit der Berührungssensorschicht verbunden ist, auf dem Berührungssubstrat ausgebildet sind.

## Revendications

1. Un procédé de fabrication d'un dispositif d'affichage tactile (100), comprenant les étapes consistant à:
(a) stratifier un module d'affichage (120) sur une surface d'un substrat tactile (112) au moyen d'un premier adhésif; le substrat tactile (112) étant substantiellement transparent, dans lequel un circuit imprimé flexible substantiellement transparent (116) est stratifié sur le substrat tactile (112) ;
(c) effectuer un durcissement à la lumière du premier adhésif pour former une première couche adhésive (130) ;
(b) stratifier une lentille (114) sur l'autre surface du substrat tactile (112) au moyen d'un second adhésif, dans lequel une zone d'ombre est formée par le recouvrement d'encre d'impression autour de la lentille (114) ; et
(d) effectuer un durcissement à la lumière du second adhésif pour former une seconde couche adhésive (118).

2. Le procédé de fabrication d'un dispositif d'affichage tactile selon la revendication 1, dans lequel le premier adhésif est un adhésif liquide durcissant à la lumière.

3. Le procédé de fabrication d'un dispositif d'affichage tactile selon la revendication 1, dans lequel le second adhésif est un adhésif liquide durcissant à la lumière.

4. Le procédé de fabrication d'un dispositif d'affichage tactile selon la revendication 2 ou 3, dans lequel l'adhésif liquide durcissant à la lumière est choisi au sein d'un groupe comprenant un adhésif liquide durcissant aux ultraviolets, un adhésif liquide à durcissement ultraviolet induit par la chaleur, un adhésif liquide à durcissement ultraviolet induit par l'humidité, ou une combinaison de ceux-ci.

5. Le procédé de fabrication d'un dispositif d'affichage tactile selon la revendication 1, dans lequel si le premier adhésif et le second adhésif sont des adhésifs liquides à durcissement ultraviolet induits par la chaleur, l'opération de durcissement à la lumière comprend en outre:
effectuer un durcissement à la lumière de l'adhésif liquide à durcissement ultraviolet au moyen de lumière ultraviolette; et
le renforcement du durcissement de l'adhésif liquide à durcissement ultraviolet induit par la chaleur au moyen d'un programme de chauffage.

6. Le procédé de fabrication d'un dispositif d'affichage tactile selon la revendication 1 dans lequel, si le premier adhésif et le second adhésif sont des adhésifs liquides à durcissement ultraviolet induits par l'humidité, l'opération de durcissement à la lumière comprend en outre:
la réalisation d'un durcissement à la lumière de l'adhésif liquide à durcissement ultraviolet par la lumière ultraviolette; et
le renforcement du durcissement de l'adhésif liquide à durcissement ultraviolet induit par l'humidité au moyen d'une humidification.

7. Un dispositif d'affichage tactile (100) obtenu au moyen du procédé de fabrication selon la revendication 1.

8. Le dispositif d'affichage tactile tel que revendiqué dans la revendication 7, das lequel la première couche adhésive et la deuxième couche adhésive sont choisies au sein d'un groupe comprenant un adhésif liquide à durcissement par ultraviolet, un adhésif liquide à durcissement par ultraviolet induit par la chaleur, un adhésif liquide à durcissement par ultraviolet et induit par l'humidification, et une combinaison de ceux-ci.

9. Le dispositif d'affichage tactile selon la revendication 8, dans lequel la première couche adhésive est un produit acrylique ou à base de silicium.

10. Le dispositif d'affichage tactile selon la revendication 8, dans lequel la seconde couche adhésive est un produit acrylique ou à base de silicium.

11. Le dispositif d'affichage tactile selon la revendication 7, dans lequel une couche de détection tactile et une couche de circuit environnante connectée électriquement à la couche de détection tactile sont formées sur le substrat tactile.
